(19) Europäisches Patentamt / European Patent Office / Office européen des brevets

(11) **EP 2 039 735 A1**

(12) **EUROPEAN PATENT APPLICATION**
published in accordance with Art. 153(4) EPC

(43) Date of publication:
**25.03.2009 Bulletin 2009/13**

(21) Application number: 07768273.0

(22) Date of filing: **06.07.2007**

(51) Int Cl.:
*C09J 7/02* (2006.01)  *B32B 7/10* (2006.01)
*B32B 27/22* (2006.01)  *B32B 27/30* (2006.01)
*C09J 11/06* (2006.01)  *C09J 133/08* (2006.01)
*C09J 175/04* (2006.01)

(86) International application number:
**PCT/JP2007/063541**

(87) International publication number:
**WO 2008/004650 (10.01.2008 Gazette 2008/02)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **06.07.2006 JP 2006187000**

(71) Applicant: Lintec Corporation
Tokyo 173-0001 (JP)

(72) Inventors:
• ETOH, Hiroyuki
  Tokyo 173-0001 (JP)
• TETSUMOTO, Takuya
  Tokyo 173-0001 (JP)

(74) Representative: **Cohausz & Florack**
**Patent- und Rechtsanwälte**
**Bleichstraße 14**
**40211 Düsseldorf (DE)**

(54) **ADHESIVE SHEET**

(57) An adhesive sheet comprising a substrate and an adhesive layer formed on at least one side of the substrate, **characterized in that** an adhesive agent contained in the adhesive layer comprises an acrylic ester copolymer and a citrate plasticizer; the acrylic ester copolymer has a glass transition temperature of -45˚C or less; the citrate plasticizer is contained in an amount of 1.0 to 50.0 parts by mass (solid content), with respect to 100 parts by mass (solid content) of the acrylic ester copolymer; and a rate of a gel content in the adhesive agent in the adhesive layer is 70% or more, is disclosed.

The adhesive sheet according to the present invention has a slightly-adhesive property and a removable property, and can be suitably used, for example, as a carrier sheet.

**Description**

TECHNICAL FIELD

The present invention relates to an adhesive sheet. The adhesive sheet according to the present invention can be advantageously used, for example, as a carrier sheet in processing steps of a flexible printed circuit (FPC) or punching steps of a reflection film and a diffusion film for optics, since the adhesive sheet has a moderate adhesive property and an excellent removable property.

BACKGROUND ART

With a recent development of a thinned or miniaturized flexible printed circuit board (FPC), a Copper Clad Laminate (CCL) and a polyimide film or other films, used in the FPC, also has been progressively thinned. Thus, rigidity of such firms per se is lowered and thus, processing in the manufacture of the FPC has become difficult. Therefore, a carrier sheet is widely used to stick it on a unprocessed film for the FPC whereby the rigidity can be enhanced was a whole and workability upon the processing can be simplified. After the processing, the carrier sheet can be removed. Further, similar procedures are used in the manufacture of an optical member wherein a thin film such as a polyester film is used.

As a carrier sheet, a sheet having a slightly-adhesive property and a removably property, which ensures an adhesive property in processing steps and may be easily removed after processing steps, is required, and such an adhesive sheet was proposed (for example, Patent References 1 and 2).

In a reinforcing sheet for hooding a flexible printed circuit board described, for example, in said Patent Reference 1, however, a vinyl chloride resin containing a large amount of a plasticizer in an adhesive layer is used. Therefore, it has defects, for example, in that an adherend is remarkably contaminated with a large amount of the plasticizer contained therein. Further, in an adhesive sheet described in said Patent Reference 2, an acrylic resin adhesive agent containing a phthalate ester plasticizer is used as an adhesive agent, and therefore, it has defects, for example, in that the phthalate ester plasticizer contaminate an adherend.

[Patent Reference 1] Japanese Unexamined Patent Publication (Kokai) no. 11-112125
[Patent Reference 2] Japanese Unexamined Patent Publication (Kokai) No. 5-247416

DISCLOSURE OF INVENTION

PROBLEMS TO BE SOLVED BY THE INVENTION

As above, in some adhesive sheets proposed in the past, an additive contained in an adhesive agent may move to an adherend surface, and contaminate the adhered. Further, some adhesive sheets proposed in the past may cause a zipping (nonsmooth removing with scratch) due to a high adhesive strength. When the zipping occurs, an adherend may be destructed or deformed. On the other hand, when an adhesive strength, is too low, an adhered cannot be adequately held, and thus, the adhesive sheet cannot serve as a desired adhesive sheet for processing (a carrier sheet). Further, some adhesive sheets exhibit a moderate adhesive strength at an early stage immediately after the adhesive sheet is stuck to an adhered, but the adhesive strength thereof is increased due to a temperature change or a temporal stability when a long time goes on after the sticking. If the adhesive strength is changed, a desired adhesive strength is lost, and a destruction of an adherend occurs upon removing, or an adhesive deposit which means that an adhesive agent remains on an adherend surface occurs after removing.

Therefore, the abject of the present invention is to provide an adhesive sheet wherein an adhesive property to an adhered is moderate, an alteration in an adhesive strength, after a long time (for example, several months) from the sticking is low, an increase of an adhesive strength when heated is low, a removing can be easily conducted without zipping, and an adherend contamination is low after removing.

MEANS FOR SOLVING THE PROBLEMS

The above problems can be solved by an adhesive sheet according to the present invention, comprising a substrate and an adhesive layer formed on at least one side of the substrate, characterized in that an adhesive agent contained in the adhesive layer comprises an acrylic ester copolymer and a citrate plasticizer; the acrylic ester copolymer has a glass transition temperature of -45°C or less; the citrate plasticizer is contained in an amount of 1.0 to 50.0 parts by mass (solid content), with respect to 100 parts by mass (solid content) of the acrylic ester copolymer; and a rate of a gel content in the adhesive agent in the adhesive layer is 70% or more.

According to a preferable embodiment of the adhesive sheet of the present invention, the citrate plasticizer is acetyl tributyl citrate.

According to another preferable embodiment of the adhesive sheet of the present invention, the adhesive agent in the adhesive layer is cross-linked with a cross-linking agent.

According to a still another preferable embodiment of the adhesive sheet of the present invention, a rate of an increase in an adhesive strength measured after a week from the sticking of the adhesive sheet on a polyethylene terephthalate film is 50% or less, with respect to an adhesive strength measured after 24 hours therefrom.

According to a still another preferable embodiment of the adhesive sheet of the present invention, a rate of a change in an absolute value of a contact angle measured on a surface of a polyethylene terephthalate film from which the adhesive sheet is removed after 24 hours from the sticking of the adhesive sheet on the film is 10% or less, in comparison with the case wherein a plasticizer is not contained.

EFFECTS OF THE INVENTION

The adhesive sheet according to the present invention has a moderate adhesive property to an adhered. An alteration in an adhesive strength after a long time (for example, several months) from the sticking of the present adhesive sheet is low. When heated, an increase of an adhesive strength of the present adhesive sheet is low. The present adhesive sheet can be removed without zipping. Therefore, the adhesive sheet according to the present invention can be advantageously used as a carrier sheet which does not bering about destruction or contamination of an adherend.

BEST MODE FOR CARRYING OUT THE INVENTION

The adhesive sheet according to the present invention comprises a substrate and an adhesive layer formed on at least one side of the substrate. The substrate may be, for example, paper, natural or synthetic fiber material (for example, a woven and knitted fabrics, or a nonwoven fabric) film or sheet, or a synthetic-resin film or sheet. A paper is, for example, glassing and tracing paper, each having high degree of beating, or the like. Examples of synthetic resin are polyethylene, polypropylene, or other polyolefins, polyethylene terephtalate, polybutylene terephthalate, or other polyesters, polyvinyl chloride, polystyrene, polyvinyl acetate, polybutene, polyacrylic acid, polymethacrylic acid, polyacrylic acid ester, polymethacrylic acid ester, polyvinyl alcohol, polyvinyl formal, polyvinyl butyral, polyacrylonitrile, polycarbonate, polyamide, ethylene-vinyl acetate copolymer, ethylene-acrylic ester copolymer, polyvinyl acetyl, ethyl cellulose, cellulose triacetate, hydroxypropylcellulose, or other resins. The paper, the film, or the sheet can be used alone or as a laminated product thereof.

When the adhesive sheet according to the present invention is used, for example, as a carrier sheet for a precision component, a polyester film having a high dimensional stability is preferably used as a substrate. Further, a thickness of a substrate used is preferably 10 to 200 $\mu$m.

The adhesive agent forming the adhesive layer in the adhesive sheet according to the present invention comprises an acrylic ester copolymer and a citrate plasticizer. An acrylic ester copolymer having a glass transition temperature (Tg) of -45°C or less, preferably -50°C or less, more preferable -50°C to -70°C is used. When a glass transition temperature (Tg) is higher than -45°C, a zipping may easily occur when the adhesive sheet is removed from an adherend at a high speed.

The acrylic ester copolymer, can be prepared by copolymerizing two or more alkyl (meth)acrylate esters containing an alkyl group having 1 to 14 carbon atoms, or one or more alkyl (mech)acrylate esters containing an alkyl group having 1 to 14 carbon atoms and other one or more monomers.

Acrylic ester monomers containing an alkyl group having 1 to 14 carbon atoms are, for example, methyl (meth) acrylate, ethyl (meth)acrylate, n-propyl (meth)acrylate, isopropyl (meth)acrylate, n-butyl (meth)acrylate, isobutyl (meth) acrylate, pentyl (meth)acrylate, cyclohexyl (meth)acrylate, 2-ethylhexyl (meth)acrylate, n-octyl (meth)acrylate, isooctyl (meth) acryl-ate, or lauryl (meth)acrylate or the like, and can be used alone or in combination thereof.

The acrylic ester copolymer can be a copolymer prepared by copolymerizing monomers having one or more functional groups. The monomer having one or more functional groups which can be copolymerized with an acrylic ester monomer is, for example, (meth)acrylic acid, maleic acid, itaconic acid, or crotonic acid, each having a carboxyl group; or 2-hydroxyethyl (meth)acrylate, 2-hydroxypropyl (meth)acrylate, or 2-hydroxy vinyl ether, each having a hydroxyl group; or N,N-dimethylaminoethyl (meth)acrylate, or N-t-butylaminoethyl (meth)acrylate, each having an amino group; or glycidyl (meth)acrylate having an epoxy group, or the like.

Furthermore, the acrylic ester copolymer can be a copolymer prepared by copolymerization with other monomers, such as vinyl acetate, vinyl propionate, or other vinyl esters; ethylene, propylene, isobutylene, or other olefins; vinyl chloride, vinylidene chloride, or other halogenated olefins; styrene, $\alpha$-methyl styrene, or other styrene monomers; butadiene, isoprene, chloroprene, or other diene monomers; acrylonitrile, methacrylonitrile, or other nitrile monomers.

These monomers may be used alone or in combination thereof.

The adhesive agent forming the adhesive layer in the adhesive sheet according to the present invention contains a citrate plasticizer (citric ester plasticizer). A citrate plasticizer is, for example, triethyl citrate, acetyl triethyl citrate, tributyl citrate, acetyl tributyl citrate (ATBC), or acetyl trioctyl citrate. Acetyl tributyl citrate and acetyl trioctyl citrate are preferable because an adherend contamination therewith was more reduced, in comparison with triethyl citrate, acetyl triethyl citrate, or tributyl citrate, or the like, the molecular weight of which is lower than the molecular weight of acetyl tributyl citrate and acetyl trioctyl citrate. Further, acetyl tributyl citrate, triethyl citrate, acetyl triethyl citrate, or tributyl citrate is preferable because of an excellent compatibility with an adhesive agent, in comparison with acetyl trioctyl citrate or the like, the molecular weight of which is higher than the molecular weight thereof. Further, acetyl tributyl citrate is more preferable in the adherend contamination and compatibility with the adhesive agent.

An amount of the citrate plasticizer added in the adhesive agent used in the present invention is 1.0 to 50.0 parts by mass (solid content), preferably 2.0 to 40.0 parts by mass (sold content), with respect to 100 parts by mass (solid content) of the acrylic ester copolymer. When the amount of the citrate plasticizer added is less than 1.0 part by mass, a zipping may easily occur. When the amount is more than 50.0 parts by mass, an adhered may be contaminated and the adhesiveness to a substrate may become worse.

The extent to which a plasticizer contained in the adhesive layer in the adhesive sheet according to the present invention contaminates an adherend can be evaluated by a change in a contact angle on an adhered surface. For example, when an adhesive sheet according to the present invention is used as a carrier sheet, then removed from an adhered after finishing processing steps, and consequently a plasticizer remains on the adherend, a contact angle on the adhered surface is changed. The extent of the contamination can be evaluated by measuring the extent of this change. Further, the contamination with the plasticizer may possibly cause an adhesion failure of a Copper Clad Laminate (CCL) or a polyimide film of a flexible printed circuit board (FPC), or a polyester film used in an optical member, and may adversely affect an electrical conductivity of an electronic component.

In the present invention, a rate of a change in a contact angle wherein a polyethylene terephthalate film is used as an adhered is used as an index. Specifically, an adhesive sheet sample is stuck to a polyethylene terephthalate film, then removed from the polyethylene terephthalate film after 24 hours, and a contact angle of the film surface is calculated, using a contact angle (contract angle with a plasticizer) when an adhesive agent contains a plasticizer, and a contact angle (contact angle without a plasticizer) when an adhesive agent does not contain a plasticizer, by the following formula (1):

$$A = [(B-C)/C] \times 100 \qquad (1)$$

wherein A is a rate of a change in a contact angle, B is a contact angle with a plasticizer, C is a contact angle without a plasticizer.

In the adhesive sheet according to the present invention, an absolute value of the rate (A) of the change in the contact angle can be controlled within 10% or less, preferably 7% or less, more preferably 5% or less. When an adhesive agent used has an absolute value of more than 10%, as to the rate (A) of the change in the contact angle, for an electronic component as an adherend, an adhesion failure may occur, or an electrical conductivity of an electronic component may adversely be affected, in subsequent adhering steps.

The adhesive agent in the adhesive layer used in the present invention may be prepared preferably by cross-linking with a cross-linking agent. An isocyanate-based cross-linking agent, an epoxy-based cross-linking agent, a metal chelate-based cross-linking agent, or the like can be used as the cross-linking agent. Of these agents, hexamethylene diisocyanate, tolylene diisocyanate, or xylylene diisocyanate which can react with 2-hydroxylethyl acrylate (Tg: -15°C) or 4-hydroxylbutyl acrylate (Tg: -80°C), each having one or more functional groups and a low glass transition temperature (Tg), is preferably used.

The thickness of the adhesive layer used in the adhesive sheet according to the present invention is not limited to, but generally 3 to 30 μm, preferably 5 to 20 μm. The adhesive agent may be directly applied to a substrate by a conventional method with, for example, a knife coater, a roll knife coater, a reverse coater, a die coater, a gravure coater, a bar coater or the like, and then dried to form the adhesive layer. Alternatively, the adhesive agent may be applied to a surface of a release agent layer on a release sheet by the method as above and then dried to form an adhesive layer on the surface of the release sheet. Therefore, the adhesive layer may be transferred to the substrate.

In the present invention, a rate of an increase of an adhesive strength, wherein a polyethylene terephthalate film, is used as an adherend is used as an index.

An adhesive strength of the adhesive sheet used in the present invention is preferably 10 to 200 mN/25 mm, more preferably 15 to 100 mN/25 mm, when measured for a polyethylene terephthalate film as an adhered under the conditions of an angle of 180° and a removing rate of 300 mm/min, in accordance with the method for measuring an adhesive strength, as in JIS Z 0237. When the adhesive strength is less than 10 mN/25 mm, a dry spot may be formed in an adhesive sheet. When the adhesion strength is more than 200 mN/25 mm, a thin film as an adherend may be destructed upon removing, at an actual use in a flexible printed circuit board (FPC) or an optical member.

An adhesive strength of the adhesive agent used in the present invention has an excellent temporal stability, In the present invention, a temporal stability of an adhesive strength can be calculated as follows. A sample of an adhesive sheet carrying thereof a sample of an adhesive agent is adhered to a polyethylene terephthalate film under the conditions of 23˚C and 50%RH, by reciprocating a rubber roller having 2kg (mass) once, and allowed to stand for 24 hours or 1 week under the same conditions. The adhesive sheet sample is removed under the conditions of an angle of 180˚ and a removing rate of 300 mm/min, and an adhesive strength is measured, in accordance with a method for measuring an adhesive strength as in JIS Z 0237. The rate (%) of an increase is calculated from the following formula (2):

$$D = [(E-F)/F] \times 100 \qquad (2)$$

wherein D is a rate (%) of an increase, E is an adhesive strength after a week from adhered, and F is an adhesive strength after 24 hours from adhered.

In the adhesive sheet according to the present invention, the rate (%) of an increase can be controlled within 50% or less, preferably 30% or less. When the rate (%) of an increase of an adhesive agent is more than 50%, an adherent may be destructed upon removing.

Further, an adhesive strength of the adhesive agent used in the present invention does not highly rise by a heat treatment (for example, a heat treatment at from 60˚C to 180˚C). Since an adhesive strength does not highly rise by a heat treatment, an application as a carrier sheet is limited.

In the adhesive agent used in the present invention, the rate of the gel content is 70% or more, preferably 80% or more, and a temporal stability of the rate of the gel content is also excellent. When the rate of the gel content is less than 70%, the rate of an increase of an adhesive strength may be greatly increased, after stuck to an adhered.

The adhesive agent in the adhesive layer can optionally contain additives, such as a tackifier, an antioxidant, a UV absorber, a colorant, or an antistatic agent or the like, generally contained in a conventional adhesive agent for an adhesive sheet.

The adhesive sheet according to the present invention can be protected by covering the adhesive layer with a releasing sheet. Any releasing sheet used in a conventionally known adhesive sheet or adhesive label can be used as the releasing sheet in the present invention. For example, a releasing sheet prepared by coating a releasing sheet substrate such as a poly-laminated paper (a woodfree paper prepared by bonding polyethylene), a glassine paper, a coated paper, a polyester film, or a polypropylene film, with a release agent such as a silicone-based release agent, an alkyd-based release agent, or a fluorine-base release agent.

EXAMPLES

The present invention now will be further illustrated by, but is by no means limited to, the following Examples.

Example 1:

To 100 parts by mass (solid content) of acrylic ester copolymer, prepared by copolymerizing 92.8% by mass of 2-ethylhexyl acrylate, 7.0% by mass of 2-hydroxyethyl acrylate and 0.2% by mass of acrylic acid, 9.0 parts by mass (solid content) of aliphatic isocyanate having hexamethylene diisocyanate [manufactured by Nippon Polyurethane Industry Co., Ltd.; CORONATE HX] as a cross-linking agent, and 2.5 parts by mass (solid content) of acetyl tributyl citrate (ATBC) [manufactured by Taoka Chemical Co., Ltd.] as a plasticizer were added. Then, the whole was sufficiently stirred to obtain an adhesive agent liquid for coating. The coating liquid was applied by a roll knife coater on one surface of a transparent polyethylene terephthalate film [manufactured by Mitsubishi Polyester Film GmbH; PET75T-100G] having a thickness of 75 $\mu$m so that the thickness after dried became 10 $\mu$m. Then, it was dried by heating for 1 minute at 90˚C. Thereafter, on the resulting adhesive layer, a polyester releasing film [manufactured by Mitsubishi Polyester Film GmbH; MRF#25] was laid so that a release agent layer thereon was brought into contact therewith to form an adhesive sheet.

Example 2:

The procedure described in Example 1 was repeated, except that the amount of acetyl tributyl citrate as a plasticizer was 37.5 parts by mass (solid content), to obtain an adhesive sheet.

Example 3:

The procedure described in Example 1 was repeated, except that an acrylic ester copolymer prepared by copolymerizing 68.6% by mass of 2-ethylhexyl acrylate, 30.0% by mass of methyl acrylate, 0.2% by mass of glycidyl methacrylate, and 1.2% by mass of acrylic acid was used as the acrylic ester copolymer, and the amount of acetyl tributyl citrate as a plasticizer was 12.5 parts by mass (solid content), to obtain an adhesive sheet.

Comparative Example 1:

The procedure described in Example 1 was repeated, except that acetyl tributyl citrate as a plasticizer was not used, to obtain a comparative adhesive sheet.

Comparative Example 2:

The procedure described in Example 1 was repeated, except that the amount of acetyl tributyl citrate as a plasticizer was 60.0 parts by mass (solid content), to obtain a comparative adhesive sheet.

Comparative Example 3:

The procedure described in Example 1 was repeated, except that the amount of aliphatic isocyanate having hexamethylene diisocyanate [manufactured by Nippon Polyurethane Industry Co., Ltd.; CORONATE HX] as a cross-linking agent was 3.0 parts by mass (solid content), to obtain a comparative adhesive sheet.

Comparative Example 4:

The procedure described in Example 1 was repeated, except that 12.5 parts by mass of dioctyl phthalate (DOP) [manufactured by Taoka Chemical Co., Ltd.] were used as a plasticizer instead of 2.5 parts by mass (solid content) of acetyl tributyl citrate, to obtain a comparative adhesive sheet.

Comparative Example 5:

The procedure described in Example 1 was repeated, except that an acrylic ester copolymer prepared by copolymerizing 62.8% by mass of 2-ethylhexyl acrylate, 30.0% by mass of vinyl acetate, 7.0% by mass of 2-hydroxyethyl acrylate, and 0.2% by mass of acrylic acid was used as an acrylic ester copolymer, and the amount of acetyl tributyl citrate as a plasticizer was 12.5 parts by mass (solid content), to obtain a comparative adhesive sheet.

[Evaluation of properties]

(1) Measurement of adhesive strength

An adhesive sheet sample (25 mm $\times$ 250 mm) was prepared by cutting each of the adhesive sheets obtained in Examples and Comparative Examples, and a surface of an adhesive layer of the sample was exposed by removing the releasing film therefrom. The surface of the exposed adhesive layer was stuck by reciprocating a rubber roller having 2 kg (mass) once, under the conditions of 23°C and 50% RH, on a transparent polyethylene terephthalate film [manufactured by Mitsubishi Polyester Film GmbH; PET75T-100G] having the thickness of 75 $\mu$m, which had been fixed on a stainless steel plate with an adhesive double coated tape. The whole was allowed to stand under the same conditions for 24 hours or 1 week. Then, in accordance with the method for measuring an adhesive strength, as in JIS Z 0237, the adhesive sheet sample was removed under the conditions of an angle of 180° and a removing rate of 300 mm/min, and an adhesive strength was measured.
Further, a rate (%) of an increase was calculated by the following formula (3):

$$d = [(e-f)/f] \times 100 \qquad (3)$$

wherein d is a rate (%) of an increase, e is an adhesive strength after a week from stuck, and f is an adhesive strength, after 24 hours from stuck. The results of the evaluation are shown in the following Tables 1 and 2.

(2) Measurement of the rate of the gel content

Each of the coating adhesive agent liquids prepared in Examples and Comparative Examples was applied on a surface of a release agent layer in a release sheet [manufactured by LINTEC Corporation; SP-PET 3811] with a same coating amount, and then dried at about 90˚C for one minute to obtain a dried adhesive layer. Then, on the dried adhesive layer, another release sheet [manufactured by Mitsubishi Polyester Film GmbH; MRF#25] was adhered so that a surface of a release agent layer thereof was brought into contact with the dried adhesive layer. After the whole was allowed to stand at 40˚C for 10 days for seasoning, about 0.2 g of a dried adhesive sample was taken from the dried adhesive layer, and the mass thereof (initial mass) was exactly weighted. Then, the dried adhesive sample was wrapped in a tetronmesh [#380; manufactured by NBC Inc.; UXSCREEN150-035/380TW], non-gel component in the adhesive sample was extracted by refluxing for 16 hours with soxhlet extraction using ethyl acetate as a solvent, a mass of a gel content was measured, and a rate of the gel content was determined as a ratio of a mass of the gel content to the initial mass. The results of the evaluation are shown in the following Tables 1 and 2.

(3) Measurement of removing strength

Each of the adhesive sheets obtained in Examples and Comparative Examples was fixed at the substrate side thereof onto a stainless plate with an adhesive double coated tape. A transparent polyethylene terephthalate film [manufactured by Mitsubishi Polyester Film GmbH; PET75T-100G] having a thickness of 75 $\mu$m was cut into a size of 50 mm $\times$ 100 mm to prepare a piece of a removing test film. The releasing film on the adhesive sheet was removed to expose a surface of an adhesive layer, and the removing test film piece was adhered to the exposed surface by reciprocating a rubber roller having 2 kg (mass) once, under the conditions of 23˚C and 50% RH. After the adhering, the whole was allowed to stand for 24 hours under the same conditions, the removing test film piece was removed under the conditions of an angle of 180˚ and a removing rate of 100 m/min, and a removing strength was measured in accordance with the method for measuring an adhesive strength, as in JIS Z 0237. Further, a zipping upon removing was checked by a removing sound. In the "removing strength" columns in Tables 1 and 2, z represents that a zipping occurred.

(4) Measurement of contact angle

The adhesive sheet obtained in Example 1 was adhered at the side of the adhesive layer (containing a plasticizer) onto a polyethylene terephthalate film [manufactured by Mitsubishi Polyester Film GmbH; PET75T-100G] (as an adhered film) under the conditions of 23˚C and 50% RH by reciprocating a rubber roller having 2 kg (mass) once. After the whole was allowed to stand under the conditions of 23˚C and 50% RH for 24 hours, the adhesive layer was removed from the adherend film. After ion-exchanged water was dropped onto the surface of the exposed adherend film, a contact angle (hereinafter referred to as a contact angle with a plasticizer) was measured by a contact angle meter [manufactured by Kyowa Interface Science Co., Ltd].
Similarly, the adhesive sheet obtained in Comparative Example 1 was adhered at the side of the adhesive layer (not containing a plasticizer) onto a polyethylene terephthalate film [manufactured by Mitsubishi Polyester Film GmbH; PET75T-100G] (as an adhered film) under the conditions of 23˚C and 50% RH by reciprocating a rubber roller having 2 kg (mass) once. After the whole was allowed to stand under the conditions of 23˚C and 50% RH for 24 hours, the adhesive layer was removed from the adherend film. After ion-exchanged water was dropped onto the surface of the exposed adhered film, a contact angle (hereinafter referred to as a contact angle without a plasticizer) was measured by a contact angle meter [manufactured by Kyowa Interface Science Co., Ltd].
Then, a rate of the change in the contact angle was calculated by the following formula (4):

$$a = [(b-c)/c] \times 100 \qquad (4)$$

wherein a is the rate of a change in a contact angle, b is a contact angle with a plasticizer, c is a contact angle without a plasticizer.
Further, with respect to the adhesive layer (containing a plasticizer) in each of the adhesive sheets obtained in Examples 2 to 3 and Comparative Examples 2 to 5, a contact angle with a plasticizer was measured by the same procedure. Furthermore, to compare the above respective adhesive sheets containing a plasticizer with the corresponding adhesive sheets not containing a plasticizer, the procedure described as above was repeated to prepare the adhesive sheets having the same structure except that a plasticizer was not contained in each adhesive layer. Then, a contact angle without a plasticizer on the surface of an adherend film was measured by the same procedure. The rate of a change in a contact angle was calculated from the contact angle with a plasticizer and a contact angle without a plasticizer by the same procedure, respectively.

(5) Measurement of adhesiveness

The releasing film was removed from each of the adhesive sheets obtained in Examples and Comparative Examples. The adhesive layer in the adhesive sheet was cut by dragging a utility knife in the direction from the adhesive layer to the substrate, in a depth so that the utility knife reached the substrate, to draw 11 parallel longitudinal lines having an interval of 1 mm therebetween and 11 parallel lateral lines having an interval of 1 mm therebetween. The parallel longitudinal lines and the parallel lateral lines were perpendicular to each other. Therefore, 100 small squares of 1 mm × 1 mm were formed in a square area of 10 mm × 10 mm (hereinafter referred to as a cut area). A cellophane-tape [manufactured by NICHIBAN CO. LTD.; CT-12S] was stuck on the resulting cut area, and wildly removed. Thereafter, the cut area condition was visually observed, and an adhesiveness was evaluated, based on the following criteria.

○: No transfer of the adhesive agent to the cellophane-tape was observed, and no abnormality was observed around the portions containing orthogonal cutting lines.
Δ: No transfer of the adhesive agent to the cellophane-tape was observed, but slight removing of the adhesive layers were observed around the portions containing orthogonal cutting lines.
×: Transfers of the adhesive agent to the cellophane-tape were observed.

[Table 1]

| | Example 1 | Example 2 | Example 3 |
|---|---|---|---|
| Acrylic ester copolymer Tg(˚C) | -66.7 | -66.7 | -50.0 |
| Adhesive strength after 24 hours from stuck (mN/25mm) | 61 | 20 | 84 |
| Adhesive strength after 1 week from stuck (mN/25mm) | 73 | 25 | 88 |
| Rate of increase (%) | 19.7 | 25.0 | 4.8 |
| Removing strength (mN/25mm) | 1118 | 880 | 2475 |
| Rate of gel content (%) | 97.0 | 86.5 | 81.4 |
| Contact angle without plasticizer (˚) | 62.9 | 62.9 | 60.5 |
| Contact angle (˚) | 61.5 | 60.8 | 58.4 |
| Rate of change in contact angle (%) | -2.2 | -3.3 | -3.5 |
| Adhesiveness | ○ | ○ | ○ |

[Table 2]

| | C.E. (*1) 1 | C.E. (*1) 2 | C.E. (*1) 3 | C.E. (*1) 4 | C.E. (*1) 5 |
|---|---|---|---|---|---|
| Acrylic easter copolymer Tg(˚C) | -66.7 | -66.7 | -66.7 | -66.7 | -43.3 |
| Adhesive strength after 24 hours from stuck (mN/25mm) | 110 | 15 | 330 | 69 | 62 |
| Adhesive strength after 1 week from stuck (mN/25mm) | 130 | 20 | 545 | 70 | 64 |
| Rate of increase (%) | 18.2 | 33.3 | 65.2 | 1.4 | 3.2 |
| Removing strength (mN/25mm) | 1760Z | 850 | 5320 | 1220 | 1440Z |
| Rate of gel content (%) | 97.0 | 84.2 | 67.5 | 92.5 | 81.8 |
| Contact angle without plasticizer (˚) | - | 62.9 | 62.9 | 62.9 | 66.3 |
| Contact angle (˚) | 62.9 | 56.2 | 63.0 | 70.1 | 68.4 |

(continued)

|  | C.E. (*1) 1 | C.E. (*1) 2 | C.E. (*1) 3 | C.E. (*1) 4 | C.E. (*1) 5 |
|---|---|---|---|---|---|
| Rate of change in contact angle (%) | 0 | -10.7 | 0.2 | 11.4 | 3.2 |
| Adhesiveness | ○ | × | ○ | ○ | Δ |
| *1: C. E. =Comparative Example | | | | | |

As shown in Tables 1 and 2, the adhesive sheets obtained in Examples 1 to 3 were excellent in the temporal stability of the adhesive strength, the removable property, and anti-contaminating property to an adherend.

(6) Measurement of adhesive strength after heat treatment

An adhesive sheet sample (25 mm × 250 mm) was prepared by cutting each of the adhesive sheets obtained in Example 1 and Comparative Example 1, and a surface of a adhesive layer of the sample was exposed by removing the releasing film therefrom. The surface of the exposed adhesive layer was stuck by reciprocating a rubber roller having 2 kg (mass) once, under the conditions of 23˚C and 50% RH, on a transparent polyethylene terephtalate film [manufactured by Mitsubishi Polyester Film GmbH; PET75T-100G] having the thickness of 75 μm, which had been fixed on a stainless steel plate with an adhesive double coated tape. The whole was allowed to stand under the conditions of 150˚C and 0% RH for 30 minutes, and then, under the conditions of 23˚C and 50% RH, for 1 hour. Then, in accordance with the method for measuring an adhesive strength, as in JIS Z 0237, the adhesive sheet sample was removed under the conditions of an angle of 180˚ and a removing rate of 300 mm/min, and an adhesive strength was measured. When the adhesive sheet obtained in Example 1 was used, the adhesive strength was 120 mN/25 mm, that is, an increase in an adhesive strength after a heat treatment was low, whereas when the adhesive sheet obtained in Comparative Example 1 was used, the adhesive strength was 280 mN/25 mm, that is, an adhesive strength after a heat treatment was significantly increased.

INDUSTRIAL APPLICABILITY

The adhesive sheet according to the present invention can be advantageously used as a carrier sheet, in particular, a removable thin film as a carrier sheet used for a flexible printed circuit board (FPC) and an optical member. Further, the adhesive sheet according to the present invention can be widely used as a common removable sheet having a slightly-adhesive property. Although the present, invention has been described with preference to specific embodiments, various changes and modifications obvious to those skilled in the art are possible without departing from the scope of the appended claims.

**Claims**

1. An adhesive sheet comprising a substrate and an adhesive layer formed on at least one side of the substrate, **characterized in that** an adhesive agent contained in the adhesive layer comprises an acrylic ester copolymer and a citrate plasticizer; the acrylic ester copolymer has a glass transition temperature of -45˚C or less; the citrate plasticizer is contained in an amount of 1.0 to 50.0 parts by mass (solid content), with respect to 100 parts by mass (solid content) of the acrylic ester copolymer; and a rate of a gel content in the adhesive agent in the adhesive layer is 70% or more.

2. The adhesive sheet according to claim 1, wherein the citrate plasticizer is acetyl tributyl citrate.

3. The adhesive sheet according to claim 1 or 2, wherein the adhesive agent in the adhesive layer is cross-linked with a cross-linking agent.

4. The adhesive sheet according to any one of claims 1 to 3, wherein a rate of an increase in an adhesive strength measured after a week from the sticking of the adhesive sheet on a polyethylene terephthalate film is 50% or less, with respect to an adhesive strength measured after 24 hours therefrom.

5. The adhesive sheet according to any one of claims 1 to 4, wherein a rate of a change in an absolute value of a contact angle measured on a surface or a polyethylene terephthalate film from which the adhesive sheet is removed after 24 hours from the sticking of the adhesive sheet on the film is 10% or less, in comparison with the case wherein a plasticizer is not contained.

<table>
<tr><td colspan="2">**INTERNATIONAL SEARCH REPORT**</td><td colspan="2">International application No.<br><br>PCT/JP2007/063541</td></tr>
</table>

A.   CLASSIFICATION OF SUBJECT MATTER
*C09J7/02*(2006.01)i, *B32B7/10*(2006.01)i, *B32B27/22*(2006.01)i, *B32B27/30* (2006.01)i, *C09J11/06*(2006.01)i, *C09J133/08*(2006.01)i, *C09J175/04* (2006.01)i

According to International Patent Classification (IPC) or to both national classification and IPC

B.   FIELDS SEARCHED

Minimum documentation searched (classification system followed by classification symbols)
C09J7/02, B32B7/10, B32B27/22, B32B27/30, C09J11/06, C09J133/08, C09J175/04

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)
CA, REGISTRY(STN), JSTPlus(JDreamII)

C.   DOCUMENTS CONSIDERED TO BE RELEVANT

| Category* | Citation of document, with indication, where appropriate, of the relevant passages | Relevant to claim No. |
|---|---|---|
| A | JP 2004-067958 A  (Nippon Carbide Industries Co., Ltd.),<br>04 March, 2004 (04.03.04),<br>Claims; Par. Nos. [0038] to [0039], [0059], [0062] to [0063], [0076] to [0077]<br>(Family: none) | 1-5 |
| A | JP 2005-281423 A  (Lintec Corp.),<br>13 October, 2005 (13.10.05),<br>Claims; Par. Nos. [0006], [0009] to [0010]<br>(Family: none) | 1-5 |
| A | JP 2006-008856 A  (Soken Chemical & Engineering Co., Ltd.),<br>12 January, 2006 (12.01.06),<br>Claims; Par. Nos. [0028], [0034], [0040], [0042]<br>(Family: none) | 1-5 |

☒   Further documents are listed in the continuation of Box C.          ☐   See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

Date of the actual completion of the international search
18 July, 2007 (18.07.07)

Date of mailing of the international search report
31 July, 2007 (31.07.07)

Name and mailing address of the ISA/
Japanese Patent Office

Authorized officer

Facsimile No.

Telephone No.

Form PCT/ISA/210 (second sheet) (April 2005)

**INTERNATIONAL SEARCH REPORT**

International application No.

PCT/JP2007/063541

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2006-111846 A  (Nitto Denko Corp.),<br>27 April, 2006 (27.04.06),<br>Claims; Par. Nos. [0047], [0052], [0095], [0104]<br>& US 2006/0057368 A1   & EP 1637572 A1<br>& CN 1749344 A        & KR 2006051328 A | 1-5 |
| A | JP 2006-091254 A  (Fuji Photo Film Co., Ltd.),<br>06 April, 2006 (06.04.06),<br>Claims; Par. No. [0051]<br>(Family: none) | 1-5 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11112125 A
- JP 5247416 A